# EUROPEAN PATENT APPLICATION

(11) **EP 4 687 385 A1**
(43) Date of publication of application: **04.02.2026**
(21) Application number: 24306322.9
(22) Date of filing: 02.08.2024
(51) Int. Cl.: H05K 7/20, G06F 1/20

(54) **COOLING ARRANGEMENTS FOR AUTONOMOUS RACKS**

(71) Applicant: OVH, 59100 Roubaix (FR)
(72) Inventor: BAUDUIN, Hadrien, 59650 Villeneuve d'Ascq (FR); CHEHADE, Ali, 59283 Moncheaux (FR); VAHIDI FERDOUSI, Mahdi, 59800 Lille (FR)
(74) Representative: BCF Global

(57) **Abstract**

Autonomous rack system configurations for datacenter operations are presented that include a combination of a first rack structure incorporating front-mounted heat exchanger and a second rack structure incorporating a rear-mounted heat exchanger, such that liquid-cooled heat-generating electronic components that are less tolerant to higher temperatures are disposed within the first rack structure and liquid-cooled heat-generating electronic components that are more tolerant to higher temperatures are disposed within the second rack structure. These configurations utilize the residual air flow that passes through the less temperature tolerant electronic components of the first rack structure and redirect it to the second rack structure to cool the more temperature tolerant electronic components of the second rack structure.

## Description

### FIELD

The present technology relates to cooling techniques for electronic equipment. In particular, a cooling arrangement for autonomous racks.

### BACKGROUND

Electronic equipment, for example servers, memory banks, computer discs, and the like, are conventionally grouped in equipment racks. Large data centers and other large computing facilities may contain thousands of racks supporting thousands or even tens of thousands of server racks.

The server racks consume large amounts of electric power and generate significant amounts of heat. Cooling needs are important in such racks. Indeed, some electronic devices, such as newer generation processors, operate at computation speeds that produce so much heat that they could fail within seconds in cases of inadequate cooling.

To address this heating issue, datacenter server racks mount fans on the backplanes of server racks that generate forced ventilation to extract heated air from the server racks and expel the heated air into the ambient environment. While this configuration provides some relief in various applications, other measures have been employed to assist in the further cooling of server racks.

For example, liquid cooling circulatory measures (i.e., "liquid cooling loops") including liquid cooling blocks/units and/or air-to-liquid heat exchangers, have been employed into the server racks to absorb and redirect some of the expelled heat to further cooling equipment, such as, for example, cooling towers, located outside of the data center. Mainly the use of liquid cooling wit liquid cooling blocks (*i.e.,* "direct-to-chip liquid cooling") has proven it provides better cooling performance and allows greater server racks power density.

However, there is also a need to provide autonomous racks having self-contained liquid cooling loops that are capable of being installed in environments that lack liquid cooling infrastructures while benefiting from liquid cooling blocks to service the overall cooling needs of server racks.

Even though the recent developments identified above may provide benefits, improvements are still desirable for autonomous rack implementations.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

### SUMMARY

Embodiments of the present technology are a result of developers' appreciation and study of the shortcomings associated with the prior art. In particular, such shortcomings may comprise difficulties in optimizing the cooling of components within autonomous racks.

With this said, an aspect of the present technology provides an autonomous rack system that comprises a first rack structure housing a first set of rack-mounted processing assemblies containing liquid-cooled heat-generating electronic components and air-cooled heat-generating electronic components, the first rack structure having a front side and an opposing rear side; a first air-to-liquid heat exchanger mounted to the front side of the first rack structure and configured to pull in cold ambient air towards the first set of rack-mounted processing assemblies; a first liquid cooling loop, comprising: a circulation conduit conveying cooling liquid incorporating a forward path fluidly-coupled to an output of the first air-to-liquid heat exchanger and a return path fluidly-coupled to an input of the first air-to-liquid heat exchanger; at least one liquid cooling unit thermally mounted onto the at least one liquid-cooled heat-generating electronic component of the first set of processing assemblies and fluidly-coupled to the circulation conduit to internally channel the cooling liquid therethrough; and at least one first pump to forcibly urge the flow of the cooling liquid through the forward path, the liquid cooling unit, the return path, and the first air-to-liquid heat exchanger .

Given this configuration, the cold ambient air pulled into the front side of the first rack structure by the first air-to-liquid heat exchanger is firstly warmed while cooling the first cooling liquid, flows across the first set of processing assemblies, such that the air secondly warmed by the air-cooled heat-generating electronic components of the first set of processing assemblies is expelled from the rear side of the first rack structure; along the forward path, the liquid cooling unit receives the cooling liquid from the output of the first air-to-liquid heat exchanger for internally channeling the cooling liquid therein; and along the return path the liquid cooling unit returns the internally channeled liquid after being warmed by the liquid-cooled heat-generating electronic components of the first set of processing assemblies to the input of the first air-to-liquid heat exchanger.

An additional related aspect further includes a second rack structure juxtaposedly positioned at the rear of the first rack structure, the second rack structure housing a second set of rack-mounted processing assemblies containing air-cooled heat-generating electronic components, and liquid-cooled heat-generating electronic components having operating thermal requirements that are more tolerant to higher temperature levels than the liquid-cooled heat-generating electronic components of the first set of rack-mounted processing assemblies; a second air-to-liquid heat exchanger mounted to the rear side of the second rack structure and configured to pull away warmed air from the second set of rack-mounted processing assemblies and expel the hot air from the rear side of the second rack structure; a second liquid cooling loop, comprising: a circulation conduit conveying cooling liquid incorporating a forward path fluidly-coupled to an output of the second air-to-liquid heat exchanger and a return path fluidly-coupled to an input of the second air-to-liquid heat exchanger; at least one liquid cooling unit thermally mounted onto the at least one liquid-cooled heat-generating electronic component of the second set of processing assemblies and fluidly-coupled to the circulation conduit to internally channel the cooling liquid; and at least one second pump to forcibly urge the flow of the cooling liquid through the forward path, the liquid cooling unit, the return path, and the second air-to-liquid heat exchanger.

According to this related aspect, warm air is expelled from the first set of processing assemblies flows across the second set of rack-mounted processing assemblies, such that the air warmed-up by the air-cooled heat-generating components of the second set of rack-mounted processing assemblies is expelled from the rear side of the second rack structure by the second air-to-liquid heat exchanger, where the expelled air gets warmer while cooling the second cooling liquid; the second cooling liquid of the second liquid cooling loop is warmer than the first cooling liquid of the first liquid cooling loop; along the forward path, the liquid cooling unit receives the liquid from the output of the second air-to-liquid heat exchanger for internally channeling the liquid therein; and along the return path, the liquid cooling unit returns the internally channeled liquid after being warmed by the liquid-cooled heat-generating electronic components of the second set of processing assemblies to the input of the second air-to-liquid heat exchanger

Another aspect of the present technology provides an autonomous rack system, comprising: a rack structure housing a first set of rack-mounted processing assemblies containing liquid-cooled heat-generating electronic components and air-cooled heat-generating electronic components and a second set of rack-mounted processing assemblies containing air-cooled heat-generating electronic components and liquid-cooled heat-generating electronic components having operating thermal requirements that are more tolerant to higher temperature levels than the liquid-cooled heat-generating electronic components of the first set of rack-mounted processing assemblies; a first air-to-liquid heat exchanger mounted to a front side of the rack structure and configured to pull in cold ambient air towards the first set of rack-mounted processing assemblies; a second air-to-liquid heat exchanger mounted to a rear side of the rack structure and configured to pull away warmed air from the second set of rack-mounted processing assemblies and expel the hot air from the rear side of the rack structure; a first liquid cooling loop, comprising: a first circulation conduit conveying cooling liquid incorporating a forward path fluidly-coupled to an output of the first air-to-liquid heat exchanger and a return path fluidly-coupled to an input of the first air-to-liquid heat exchanger; at least one liquid cooling unit thermally mounted onto the at least one liquid-cooled heat-generating electronic component of the first set of processing assemblies and fluidly-coupled to the circulation conduit to internally channel the cooling liquid therethrough; and at least one first pump to forcibly urge the flow of the cooling liquid through the forward path, the liquid cooling unit, the return path, and the first air-to-liquid heat exchanger; a second liquid cooling loop, comprising: a second circulation conduit conveying cooling liquid incorporating a forward path fluidly-coupled to an output of the second air-to-liquid heat exchanger and a return path fluidly-coupled to an input of the second air-to-liquid heat exchanger; at least one liquid cooling unit thermally mounted onto the at least one liquid-cooled heat-generating electronic component of the second set of processing assemblies and fluidly-coupled to the circulation conduit to internally channel the cooling liquid therethrough; and at least one second pump to forcibly urge the flow of the cooling liquid through the forward path, the liquid cooling unit, the return path, and the second air-to-liquid heat exchanger.

In this configuration, the cold ambient air pulled into the front side of the rack structure by the first air-to-liquid heat exchanger, is firstly warmed while cooling the first cooling liquid of the first liquid cooling loop and flows across the first and second sets of processing assemblies, such that the air warmed by the air-cooled heat-generating electronic components of the first and second sets of processing assemblies is expelled from the rear side of the rack structure by the second air-to-liquid heat exchanger, where the expelled air gets warmer while cooling the second cooling liquid of the second liquid cooling loop; the second cooling liquid of the second liquid cooling loop is warmer than the first cooling liquid of the first liquid cooling loop; along the forward path of the first circulation conduit, the liquid cooling unit receives the cooling liquid from the output of the first air-to-liquid heat exchanger for internally channeling the cooling liquid therein and along the return path, the liquid cooling unit returns the internally channeled liquid after being warmed by the liquid-cooled heat-generating electronic components of the first set of processing assemblies to the input of the first air-to-liquid heat exchanger; and along the forward path of the second circulation conduit, the liquid cooling unit receives the cooling liquid from the output of the second air-to-liquid heat exchanger for internally channeling the cooling liquid therein and along the return path, the liquid cooling unit returns the internally channeled liquid after being warmed by the liquid-cooled heat-generating electronic components of the second set of processing assemblies to the input of the second air-to-liquid heat exchanger.

With this said, within the context of the present specification, unless expressly provided otherwise, electronic equipment may refer, but is not limited to, "servers", "electronic devices", "operation systems", "systems", "computer-based systems", "controller units", "monitoring devices", a "control devices" and/or any combination thereof appropriate to the relevant task at hand.

Additionally, within the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned objects and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1 is a schematic diagram of a side view of an autonomous server rack incorporating a front-mounted heat exchanger, in accordance with the embodiments of the present disclosure;
FIG. 2 is a schematic diagram of a side view of an autonomous dual server rack incorporating a front-mounted heat exchanger and a rear-mounted heat exchanger, as well as a front-loading server sub-rack and a rear-loading server sub-rack, in accordance with the embodiments of the present disclosure;
FIGs. 3A, 3B depict schematic side views of a datacenter room for accommodating two different server rack configurations, in accordance with the embodiments of the present disclosure; and
FIG. 4 is a schematic diagram of a side view of an autonomous server rack configuration incorporating a front-mounted heat exchanger and a rear-mounted heat exchanger, in accordance with the embodiments of the present disclosure; and
FIG. 5 is a schematic diagram of a side view of an another autonomous server rack configuration similar to the autonomous server rack configuration incorporating a front-mounted heat exchanger and a rear-mounted heat exchanger, in accordance with the embodiments of the present disclosure.

It should be understood that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future.

An aspect of the present technology introduces a cooling arrangement for autonomous cooling of a rack, for example a server rack, hosting at least one liquid-cooled heat generating component, at least one air-cooled heat-generating component and at least one fan. The cooling arrangement comprises a closed loop and an open loop. The closed loop provides liquid cooling for the liquid-cooled heat-generating component. The open loop provides air cooling for the air-cooled heat-generating component with the at least one fan pulling fresh air from the front of the server rack and expelling heated air to the rear of the server rack. A liquid, for example water, is initially fed to the closed loop, and while circulating therein, is brought to a hotter temperature by the heat exhausted by the liquid-cooled heat-generating component. The hotter liquid is then circulated within an air-to-liquid heat exchanger at a junction between the open loop and the closed loop. The hotter liquid of the closed loop is cooled by thermal transfer from the closed loop to the open loop in the air-to-liquid heat exchanger. The cooler liquid from the closed loop is recirculated back for recooling the liquid-cooled heat-generating component. The air from the open loop, which has increased in temperature, is expelled from the open loop for an exterior exhaust and/or treatment.

With these fundamentals in place, we will now consider some non-limiting examples to illustrate various implementations of aspects of the present technology.

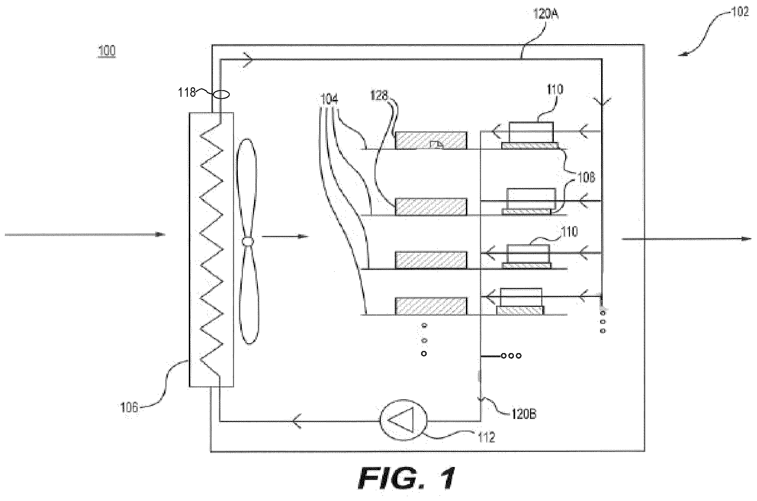

FIG. 1 is a schematic diagram of a side view of an autonomous server rack configuration **100** incorporating a front-mounted heat exchanger, in accordance with the embodiments of the present disclosure. As shown, autonomous server rack configuration **100** comprises a first rack structure **102** housing a first set of rack-mounted processing assemblies **104** containing liquid-cooled heat-generating electronic components **108** and air-cooled heat-generating electronic components **128.** In certain operations, such liquid-cooled heat-generating electronic components **108** may be more sensitive to *(i.e.,* less tolerant of) high temperature levels and require optimal cooling with low coolant temperatures. For example, some temperature sensitive electronic components **108** may require liquid inlet temperature to be approximately < 35°C and/or liquid outlet temperature approximately < 40°C.

To service the cooling needs of these liquid-cooled heat-generating electronic components **108,** unlike conventional rack installations, the autonomous server rack configuration **100** incorporates a first air-to-liquid heat exchanger **106** mounted on a front side of the rack structure **102** and equipped with at least one fan. That is, conventional rack installations mount air-to-liquid heat exchangers on a rear side of the rack to cool the cooling liquid with warm air, and extract heated air away from the rack and expel into ambient environment (hot ambient air, typically in a "hot aisle" to be expelled or retreated/recooled by the conventional data center infrastructure). However, the first front-mounted heat exchanger **106** serves to pull in cold ambient air to increase the air-to-liquid cooling capacity thereof, cool the cooling liquid heated by the liquid-cooled heat-generating electronic components **108,** and distribute the slightly warmed air throughout the rack. Typically, cold ambient air is pulled from a "cold aisle" wherein air temperature is comprised between around 24°C and 27°C. The detailed configuration may work up to cold ambient air temperature around 32°C. As such, air firstly warmed by flowing across the air-to-liquid heat exchanger is still at sufficiently low temperature (e.g., does not exceed 30°C to 37°C) to cool the air-cooled heat-generating electronic components **128.** The air secondly warmed is subsequently expelled away through a rear side of the rack structure **102.**

The front-mounted heat exchanger **106** is equipped with an input *(not shown)* for receiving warm liquid from the liquid-cooled heat-generating electronic components **108** and an output *(not shown)* for forwarding recooled liquid back to the liquid-cooled heat-generating electronic components **108.** In certain embodiments, air-to-liquid heat exchanger **106** may be embodied as a finned heat exchanger (FHEX). In certain embodiments, air-to-liquid heat exchanger **106** is part of a front door (e.g., front door heat exchanger, as opposed to conventional rear door heat exchanger), equipped, for example, with hinges.

Moreover, the first front-mounted heat exchanger **106** is fluidly-coupled to a first liquid cooling loop **118** comprising a first circulation conduit **120** that conveys cooling liquid. In particular, the first circulation conduit **120** comprises a forward path **120A** fluidly-coupled to the output of the first front-mounted heat exchanger **106** for forwarding cool/recooled liquid to the liquid-cooled heat-generating electronic components **108** and a return path **120B** fluidly-coupled to the input of the first front-mounted heat exchanger **106** for receiving warmed liquid from the liquid-cooled heat-generating electronic components **108** for recooling operations thereby.

As such, the first liquid cooling loop **118** is fluidly-coupled to at least one liquid cooling unit **110** that is thermally-mounted on a corresponding liquid-cooled heat-generating electronic component **108.** The liquid cooling unit **110** is configured with a continuous internal channel that allows for the passage of cooling liquid therethrough.

The autonomous server rack configuration **100** further incorporates at least one pump **112** to forcibly urge the flow of the cooling liquid along the forward path **120A** for supplying the at least one liquid cooling unit **110** with cool/recooled liquid and for urging the flow of warmed liquid along the return path **120B** back to the first air-to-liquid heat exchanger **106** for recooling operations. In certain cases, two or more pumps may be implemented and may be arranged in series or parallel configurations. In some embodiments, there is a plurality of liquid cooling units **110** and the forward path **120A** and return path **120B** include cooling distribution units to fluidly-couple in parallel the liquid cooling units **110** or with a combination of series and parallel arrangement.

In some embodiments, the first rack structure **102** of the autonomous server rack configuration **100** is mechanically divided into a plurality of vertical columns horizontally or vertically adjacent, and the first front-mounted heat exchanger **106** is a plurality of first front-mounted heat exchangers **106.** For example, in some cases, the first rack structure **102** may be arranged with three horizontally adjacent vertical columns, each of them being equipped with a first front-mounted heat exchanger **106,** with the three front-mounted heat exchangers **106** being fluidly connected in a parallel configuration.

In this manner, the autonomous server rack configuration **100** provides a cooling configuration that optimizes, both air cooling and liquid cooling measures for liquid-cooled heat-generating electronic components **108** and air-cooled heat-generating electronic components **128.** Firstly, the first front-mounted air-to-liquid heat exchanger **106** operates to pull in cold ambient air into the front side of the first rack structure **102,** thus, front mounted air-to-liquid heat exchanger **106** increases its capacity for recooling warmed liquid received from the liquid-cooled heat-generating electronic components **108** and forward the recooled liquid back to the liquid-cooled heat-generating electronic components **108** via the first liquid cooling loop **118.** Secondly, air firstly warmed flows across the first set of processing assemblies **104** at sufficiently low temperature for cooling the air-cooled heat-generating electronic components **128.** In other words, as opposed to the conventional configuration with rear-mounted heat exchanger, liquid cooling is optimized performance-wise by working at lower liquid temperatures, and air cooling is optimized energy efficient-wise by working at higher air temperature - while still complying with electronics thermal requirements.

In some embodiments, the air and liquid temperatures of the autonomous server rack configuration **100,** as well as the temperature of the heat-generating electronic components **108** and **128** are monitored. In such embodiments, the rotation speed of fans mounted on the heat exchanger **106** and the rotation speed of pump **112** are controlled to deliver the right flow rates for reaching adapted cooling fluid temperatures and optimizing the cooling of the heat-generating electronic components **108** and **128.** Besides, in such embodiments, energy usage efficiency may be optimized.

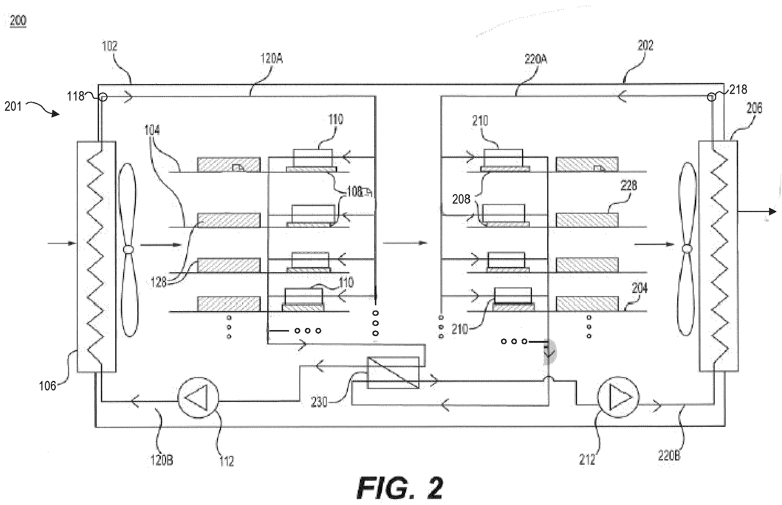

In a related embodiment, FIG. 2 is a schematic diagram of a side view of an autonomous dual server rack configuration **200** incorporating a front-mounted heat exchanger and a rear-mounted heat exchanger, in accordance with the embodiments of the present disclosure.

The autonomous dual server rack configuration **200** exploits the advantages of the autonomous server rack configuration **100** noted above to extend the operations thereof to a dual server rack structure **201** that efficiently handles the cooling needs of heat-generating electronic components with different thermal requirements.

As shown, autonomous dual server rack configuration **200** comprises a rack structure **201** that combines two autonomous server racks **102, 202** disposed in back-to-back fashion. Specifically, the first autonomous server rack **102,** as described above relative to the autonomous server rack configuration **100,** is positioned at the front side of the rack structure **201** while the second autonomous server rack **202** is juxtaposedly positioned at the rear side of the first autonomous server rack **102.** The second autonomous server rack **202** houses a second set of rack-mounted processing assemblies **204** containing liquid-cooled heat-generating electronic components **208** and air-cooled heat-generating electronic components **228.** For purposes of brevity and tractability, the noted component operations of the first autonomous server rack **102** detailed above, will not be repeated unless such components bear on the overall operations of the autonomous dual server rack **200.**

The autonomous dual server rack configuration **200** is designed to service the cooling needs of liquid-cooled heat-generating electronic components **108** that are less tolerant of higher operating temperature levels requiring optimal cooling measures as well as service the cooling needs of liquid-cooled heat-generating electronic components **208** that are more tolerant to higher operating temperature levels requiring adequate cooling measures.

With this said, the autonomous dual server rack configuration **200** installs the liquid-cooled heat-generating electronic components **108** that require optimal cooling measures in the first autonomous server rack **102** of the dual server rack structure **201.** As noted above, the first autonomous server rack **102** employs a first front-mounted air-to-liquid heat exchanger **106** to pull in cold ambient air to cool the cooling liquid heated by the liquid-cooled heat-generating electronic components **108,** and then distribute the slightly warmed air throughout the first server rack **102** for cooling the air-cooled heat-generating electronic components **128,** with heated air being expelled away through the rear side of the first server rack **102.**

In turn, the autonomous dual server rack configuration **200** installs the liquid-cooled heat-generating electronic components that are more tolerant to higher operating temperature levels in the second autonomous server rack **202.** In particular, the second autonomous server rack **202** incorporates a second heat exchanger **206** mounted on the rear side of the second autonomous server rack **202** and equipped with at least one fan. The rear-mounted heat exchanger **206** operates to pull warmed air from the rear side of the first server rack **102,** entering the second server rack **202** at sufficiently low temperature (e.g., does not exceed 35°C to 42°C) to cool the air-cooled heat-generating electronic components **228.** Flowing air warmed-up by the air-cooled heat-generating electronic components **228** is then pulled by the rear-mounted heat exchanger **206,** which cools the cooling liquid heated by the liquid-cooled heat-generating electronic components **208** and expels the warmer air into ambient environment.

The second rear-mounted heat exchanger **206** is equipped with an input *(not shown)* for receiving warm liquid from the liquid-cooled heat-generating electronic components **208** and an output *(not shown)* for forwarding recooled liquid back to the liquid-cooled heat-generating electronic components **208.** In certain embodiments, the rear air-to-liquid heat exchanger **206** may be embodied as a finned heat exchanger (FHEX). In certain embodiments, air-to-liquid heat exchanger **206** is part of a rear door (e.g., rear door heat exchanger), equipped, for example, with hinges.

The second rear-mounted heat exchanger **206** is fluidly-coupled to a second liquid cooling loop **218** comprising a second circulation conduit **220** that conveys cooling liquid. In particular, the second circulation conduit **220** comprises a forward path **220A** fluidly-coupled to the output of the second rear-mounted heat exchanger **206** for forwarding cool/recooled liquid to the liquid-cooled heat-generating electronic components **208** and a return path **220B** fluidly-coupled to the input of the second rear-mounted heat exchanger **206** for receiving warmed liquid from the liquid-cooled heat-generating electronic components **208** for recooling operations thereby. The second cooling liquid of the second liquid cooling loop **218** is warmer than the first cooling liquid of the first cooling loop **118.**

As such, the second liquid cooling loop **218** is fluidly-coupled to at least one liquid cooling unit **210** that is thermally-mounted on a corresponding heat-generating electronic component **208.** The liquid cooling unit **210** is configured with a continuous internal channel that allows for the passage of cooling liquid therethrough.

The second autonomous server rack **202** also incorporates at least one pump **212** to forcibly urge the flow of the cooling liquid along the forward path **220A** for supplying the at least one liquid cooling unit **210** with cool/recooled liquid and for urging the flow of warmed liquid along the return path **220B** back to the second air-to-liquid heat exchanger **206** for recooling operations. In certain cases, two or more pumps may be implemented and may be arranged in series or parallel configurations. In some embodiments, there is a plurality of liquid cooling units **210** and the forward path **220A** and return path **220B** include cooling distribution units to fluidly-couple in parallel the liquid cooling units **210** or with a combination of series and parallel arrangement.

Furthermore, in certain cases, at least one plate heat exchanger (PHEX) **230** may be implemented between the first and second liquid cooling loops **118, 218** for cooling improvement and/or safety concerns. The PHEX **230** may be completed by a monitoring of liquid temperatures, actuated valves, and at least one by-pass to adjust the thermal transfer therein.

Therefore, as shown, the autonomous dual server rack configuration **200** provides a cooling configuration that services the cooling needs of two server racks **102, 202** that are abutted against each other. As detailed above, the first server rack **102** incorporates liquid-cooled heat-generating electronic components **108** that are less tolerant of higher operating temperature levels while the second server rack **202** incorporates liquid-cooled heat-generating electronic components **208** that are more tolerant to higher operating temperature levels. For example, some high-temperature-tolerant electronic components **208** may work with liquid inlet temperature up to around 55°C and/or liquid outlet temperature up to around 60°C. In some embodiments, air-cooled heat-generating electronic components **228** incorporated in the second server rack **202** may also be more tolerant to higher operating temperature levels than air-cooled heat-generating electronic components **128** incorporated in the first server rack **102.**

Accordingly, the first server rack **102** employs a front-mounted heat exchanger **106** that pulls in cold ambient air that is distributed throughout the first server rack 102 and flows out of the rear side of the rack **102.** The entering air is firstly warmed while flowing across the front-mounted heat exchanger **106** wherein the cooling liquid of the first cooling loop heated by the liquid-cooled heat-generating electronic components **108** is recooled. The air is secondly warmed up while cooling the air-cooled heat-generating electronic components **128** before it exits the first server rack **102** and flows into the front side of the second server rack **202.** As the air is then still at sufficiently low temperature, the air flow is still capable of cooling the air-cooled heat-generating electronic components **228.** The further heated air flows then across the rear-mounted heat exchanger **206** wherein it gets even hotter while the cooling liquid of the second cooling loop heated by the liquid-cooled heat-generating electronic components **208** is recooled. The hot air is eventually extracted from the second server rack **202** by the rear-mounted heat exchanger **206** that pulls the further heated air away and expels it into the ambient environment. It will be appreciated that the hotter air expelled by the rear-mounted heat exchanger **206** is directed to an area (e.g., a "hot aisle") that is substantially opposite to, and distanced apart from, the area *(e.g.,* a "cold aisle") where the front-mounted heat exchanger **106** pulls in cold ambient air.

In some embodiments, the second server rack **202** of the autonomous dual server rack configuration **200** is mechanically divided into a plurality of vertical columns horizontally or vertically adjacent, and the second rear-mounted heat exchanger **206** is a plurality of second rear-mounted heat exchangers **206.** For example, in some cases, the second server rack **202** may be arranged with three horizontally adjacent vertical columns, each of them being equipped with a second rear-mounted heat exchanger **206,** with the three rear-mounted heat exchangers **206** being fluidly connected in a parallel configuration.

In this manner, the autonomous dual server rack configuration **200** provides a cooling configuration that optimizes, both air cooling and liquid cooling measures for less high-temperature-tolerant liquid-cooled electronic components **108** and higher-temperature-tolerant liquid-cooled electronic components **208,** as well as the air-cooled electronic components **128** and **228.** As described previously in detail, the cooling measures use a broad range of fluid cooling temperature with the right level of temperature according to each component and their requirements.

In some embodiments, the air and liquid temperatures of the autonomous dual server rack configuration **200,** as well as the temperature of the heat-generating electronic components **108, 128, 208, 228** are monitored. In such embodiments, the rotation speed of fans mounted on the heat exchangers **106, 206** and the rotation speed of pumps **112, 212** are controlled to deliver the right flow rates for reaching adapted cooling fluid temperatures and optimizing the cooling of the heat-generating electronic components **108, 128, 208, 228.** Besides, in such embodiments, energy usage efficiency may be optimized.

The rack structure **201** of the autonomous dual server rack configuration **200** may be monobloc in some embodiments. In other embodiments, the rack structure **201** could consist of a structure capable of receiving respective sub-structures of the first server rack **102** and the second server rack **202.** In some implementations the rack structure **201** is an assembly kit of the juxtaposed respective structures of the first server rack **102** and the second server rack **202** bounded together by binding elements.

Moreover, given the overall architecture of the autonomous dual server rack configuration **200,** a contemplated embodiment includes the first and/or second liquid cooling loops supporting the conveyance of a cooling fluid that is capable of changing phase from liquid to gas during absorption of heat, such as, vaporization at the cooling units **110, 210** *(i.e.,* evaporator operations). Commensurately, the cooling fluid is also capable of changing phase from gas back to liquid during the release of heat, such as, condensation at the finned heat exchangers (FHEX) **106, 206** (*i.e*., condenser operations). In this embodiment, the first and/or second liquid cooling loops benefit from the latent heat capacity that is higher than the specific heat capacity involved in heat transfer by convection.

Relatedly, for the noted contemplated embodiment, the cooling fluid may be selected based on its saturation temperature according to the front or rear positioning within the overall rack structure. For example, if both first and second liquid cooling loops use two-phase cooling fluid, then the saturation temperature of the first cooling fluid will be lower than the saturation temperature of the second cooling fluid. The two cooling loops may also be configured to operate at different pressure levels to adjust their respective boiling points.

Additionally, the first cooling fluid and the second cooling fluid may differ on other fluid characteristics, such as dielectric properties, which could be chosen according to costs, performances, and security considerations.

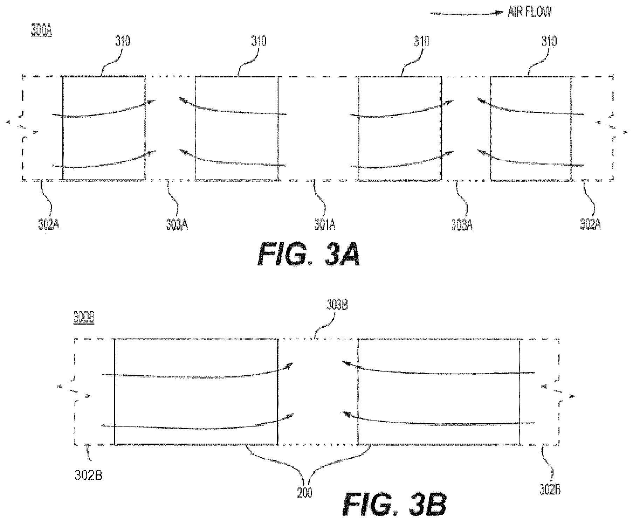

With this said, FIGs. 3A, 3B depict schematic side views of a datacenter room for accommodating two different server rack configurations, in accordance with the embodiments of the present disclosure. The datacenter installation arrangement of multiple racks of dual server rack configuration **200** and the corresponding cold and hot aisles allow a significant reduction of footprint and thus an increase of server density, as the number of aisles is reduced for a same amount of servers. For example, FIG. 3A illustrates four rows of conventional *(i.e.,* non-dual) server racks **310** (e.g., server racks of server rack configuration **100)** with two shared hot aisles **303A,** one shared cold aisle **301A,** and two dedicated half cold aisles **302A.** Moreover, FIG. 3B illustrates two rows of server racks of dual server rack configuration **200** incorporating the same number of servers as FIG. 3A, one shared hot aisle **303B** and two dedicated half cold aisles **302B.** The extension of the configuration depicted on FIG. 3B to more rows of server racks of dual server rack configuration **200** introduces at least one shared cold aisle **301B,** the at least one shared cold aisle **301B** having the same width as the at least one shared hot aisle **303B,** similar to the width of a conventional shared cold aisle **301A.** The latter configuration permits a footprint reduction from 15% to 20% compared to conventional footprints.

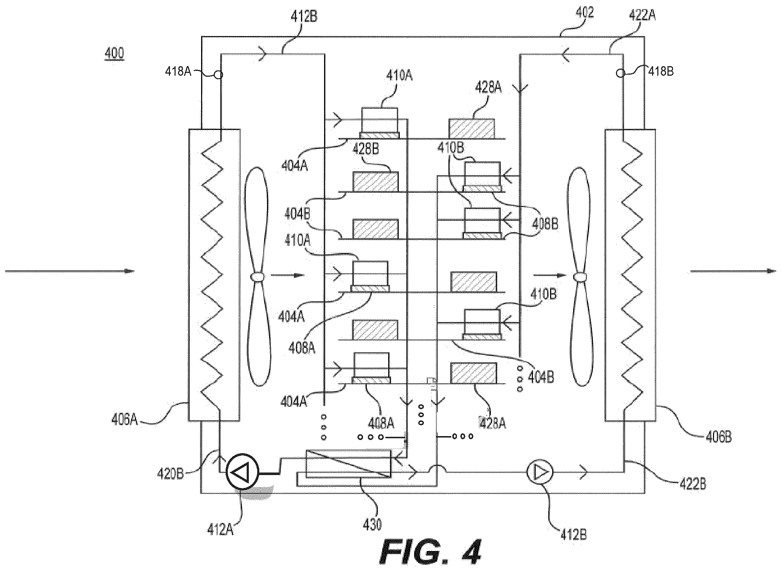

FIG. 4 is a schematic diagram of a side view of an autonomous server rack configuration **400** incorporating a front-mounted heat exchanger **406A** servicing a first liquid cooling loop **418A** and a rear-mounted heat exchanger **406B** servicing a second liquid cooling loop **418B,** in accordance with the embodiments of the present disclosure. For purposes of brevity and tractability, operations of the autonomous server rack configuration **400** components that are similar to components detailed above by the previously-disclosed embodiments, will not be repeated unless such components bear on the overall operations of the autonomous server rack **400.**

As shown, autonomous server rack configuration **400** comprises a rack structure **402** that houses a first set of rack-mounted processing assemblies **404A** containing liquid-cooled heat-generating electronic components **408A** that are less tolerant to higher operating temperature levels and a second set of rack-mounted processing assemblies **404B** containing liquid-cooled heat-generating electronic components **408B** that are more tolerant to higher operating temperature levels. Both set of rack-mounted assemblies **404A, 404B** also include air-cooled heat-generating electronic components **428A, 428B.**

A first air-to-liquid heat exchanger **406A** is mounted on a front side of the rack **402** and equipped with at least one fan. The front-mounted heat exchanger **406A** operates to pull in cold ambient air to cool the cooling liquid heated by the liquid-cooled heat-generating electronic components **408A,** and then distribute the slightly warmed air throughout the rack **402.** The front-mounted heat exchanger **406A** is fluidly-coupled to a first liquid cooling loop **418A** comprising a first circulation conduit **420** that conveys cooling liquid. In particular, the first circulation conduit **420** comprises a forward path **420A** fluidly-coupled to an output of the front-mounted heat exchanger **406A** for forwarding cool/recooled liquid to the liquid-cooled heat-generating electronic components **408A** and a return path **420B** fluidly-coupled to an input of the front-mounted heat exchanger **406A** for receiving warmed liquid from the liquid-cooled heat-generating electronic components **408A** for recooling operations thereby. The firstly warmed air exiting the front-mounted heat exchanger **406A** is at sufficiently low temperature (e.g., does not exceed 30°C to 37°C) to cool the air-cooled heat-generating electronic components **428A, 428B.**

Each of the liquid-cooled heat-generating electronic components **408A** incorporates a liquid cooling unit **410A** that is thermally-mounted thereon and is fluidly-coupled to the first liquid cooling loop **418A.** The liquid cooling unit **410A** is configured with a continuous internal channel that allows for the passage of cooling liquid therethrough, as supplied by the first liquid cooling loop **418A.**

The autonomous server rack configuration **400** also incorporates at least one pump **412A** to forcibly urge the flow of the cooling liquid along the forward path **420A** for supplying the at least one liquid cooling unit **410A** with cool/recooled liquid and for urging the flow of warmed liquid along the return path **420B** back to the front-mounted heat exchanger **406A** for recooling operations. In certain cases, two ore more pumps may be implemented and may be arranged in series or parallel configurations. In some embodiments, there is a plurality of liquid cooling units **410A** and the forward path **420A** and return path **420B** include cooling distribution units to fluidly-couple in parallel the liquid cooling units **410A** or with a combination of series and parallel arrangement.

The autonomous server rack configuration **400** further comprises a second air-to-liquid heat exchanger **406B** mounted on a rear side of the rack **402** and equipped with at least one fan. The rear-mounted heat exchanger **406B** operates to pull air secondly warmed by the air-cooled heat-generating electronic components **428A, 428B** to cool the cooling liquid heated by the liquid-cooled heat-generating electronic components **408B,** and then expels the hot air into the ambient environment. The rear-mounted heat exchanger **406B** is fluidly-coupled to a second liquid cooling loop **418B** comprising a second circulation conduit **422** that conveys cooling liquid. In particular, the second circulation conduit **422** comprises a forward path **422A** fluidly-coupled to an output of the front-mounted heat exchanger **406B** for forwarding cool/recooled liquid to the liquid-cooled heat-generating electronic components **408B** and a return path **422B** fluidly-coupled to an input of the front-mounted heat exchanger **406B** for receiving warmed liquid from the liquid-cooled heat-generating electronic components **408B** for recooling operations thereby.

Each of the liquid-cooled heat-generating electronic components **408B** incorporates a liquid cooling unit **410B** that is thermally-mounted thereon and is fluidly-coupled to the second liquid cooling loop **418B.** The liquid cooling unit **410B** is configured with a continuous internal channel that allows for the passage of cooling liquid therethrough, as supplied by the second liquid cooling loop **418B.**

The autonomous server rack configuration **400** also incorporates at least one pump **412B** to forcibly urge the flow of the cooling liquid along the forward path **422A** for supplying the at least one liquid cooling unit **410B** with cool/recooled liquid and for urging the flow of warmed liquid along the return path **422B** back to the rear-mounted heat exchanger **406B** for recooling operations. In certain cases, two or more pumps may be implemented and may be arranged in series or parallel configurations. In some embodiments, there is a plurality of liquid cooling units **410B** and the forward path **422A** and return path **422B** include cooling distribution units to fluidly-couple in parallel the liquid cooling units **410B** or with a combination of series and parallel arrangement.

Furthermore, in certain cases, a plate heat exchanger (PHEX) **430** may be implemented between the first and second liquid cooling loops **418A, 418B** for cooling improvement and/or safety concerns. The PHEX **430** may be completed by a monitoring of liquid temperatures, actuated valves, and at least one by-pass to adjust the thermal transfer therein.

Accordingly, the front-mounted heat exchanger **406A** operates to pull in cold ambient air that is distributed throughout the server rack **402** to initially extract heat from the cooling liquid of the first liquid cooling loop warmed by the less high-temperature-tolerant electronic components **408A.** The air that is, indirectly, warmed by the liquid-cooled heat-generating electronic components **408A** is, in turn heated up by the air-cooled heat-generating electronic components **428A, 428B,** used to extract heat from the cooling liquid of the second liquid cooling loop warmed by the more high-temperature-tolerant electronic components **408B,** and then extracted from the server rack **402** by the rear-mounted heat exchanger **406B** that pulls the warmed air away and expels it into the ambient environment. It will be appreciated that the hot air expelled by the rear-mounted heat exchanger **406B** is directed to an area (e.g., a "hot aisle") that that is substantially opposite to, and distanced apart from, the area (e.g., a "cold aisle") where the front-mounted heat exchanger **406A** pulls in cold ambient air.

In some embodiments, the rack structure **402** of the autonomous server rack configuration **400** is mechanically divided into a plurality of vertical columns horizontally or vertically adjacent, the first front-mounted heat exchanger **406A** is a plurality of first front-mounted heat exchangers **406A,** and the second rear-mounted heat exchanger **406B** is a plurality of second rear-mounted heat exchangers **406B.** For example, in some cases, the rack structure **402** may be arranged with three horizontally adjacent vertical columns, each of them being equipped with a first front-mounted heat exchanger **406A** and a second rear-mounted heat exchanger **406B,** with the three front-mounted heat exchangers **406A** being fluidly connected in a parallel configuration, and the three rear-mounted heat exchangers **406B** being fluidly connected in a parallel configuration. In certain embodiments, each of the air-to-liquid heat exchangers **406A** (resp. **406B)** are part of a front (resp. rear door) (e.g., front (resp. rear) door heat exchanger), equipped, for example, with hinges.

In this manner, autonomous server rack configuration **400** provides a cooling configuration that optimizes, both air cooling and liquid cooling measures for less high-temperature-tolerant liquid-cooled electronic components **408A** and higher temperature tolerant electronic components **408B,** as well as the air-cooled electronic components **428A** and **428B.** As described previously in details, the cooling measures use a broad range of fluid cooling temperature with the right level of temperature according to each component and their requirements.

Furthermore, the autonomous server rack configuration **400** may, at first glance, appear to be more expensive than a conventional rack configuration, since the numbers of heat-exchangers, fans and pumps are higher, but as the heat load to recover from the two liquid cooling loops **418A, 418B** is shared between the first front and second rear heat exchangers **406A** and **406B,** they can be chosen smaller and lighter. Accordingly, the pumps and fans can also be smaller and less energy consuming, as their operating points may require lower flow rate and/or lower pressure increase.

In some embodiments, the air and liquid temperatures of the autonomous server rack configuration **400,** as well as the temperature of the heat-generating electronic components **408A, 428A, 408B, 428B** are monitored. In such embodiments, the rotation speed of fans mounted on the heat exchangers **406A, 406B** and the rotation speed of pumps **412A, 412B** are controlled to deliver the right flow rates for reaching adapted cooling fluid temperatures and optimizing the cooling of the heat-generating electronic components **408A, 428A, 408B, 428B.** Besides, in such embodiments, energy usage efficiency may be optimized.

In alternative embodiments, the rack-mounted processing assemblies **404A** and **404B** have their own integrated compact fans and these ones may be powerful enough for assuring a contribution to the air flow with a sufficient static pressure to allow the removal of the at least one fan for the first air-to-liquid heat exchanger **406A** or for the second air-to-liquid heat exchanger **406B.** In such embodiments, if the air-to-liquid heat exchangers **406A** and **406B** are respectively part of a front door and a rear door, the air-to-liquid heat exchanger equipped with at least one fan is then part of an active (front or rear) door heat exchanger, while the air-to-liquid heat exchanger without fan is part of a passive (front or rear) door heat exchanger.

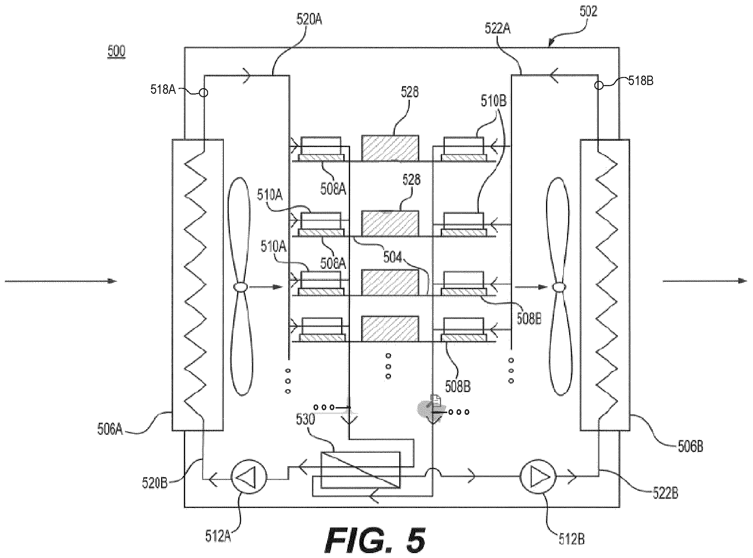

FIG. 5 is a schematic diagram of a side view of an autonomous server rack configuration **500** similar to the autonomous server rack configuration **400** incorporating a front-mounted heat exchanger **506A** servicing a first liquid cooling loop **518A** and a rear-mounted heat exchanger **506B** servicing a second liquid cooling loop **518B,** in accordance with the embodiments of the present disclosure. For purposes of brevity and tractability, operations of the autonomous server rack configuration **500** components that are similar to components detailed above by the previously-disclosed embodiments, will not be repeated unless such components bear on the overall operations of the autonomous server rack **500.**

As shown, autonomous server rack configuration **500** comprises a rack structure **502** that houses a set of rack-mounted processing assemblies **504** containing both a first set of liquid-cooled heat-generating electronic components **508A** that are less tolerant to higher operating temperature levels and a second set of liquid-cooled heat-generating electronic components **508B** that are more tolerant to higher operating temperature levels. For example, the liquid-cooled heat-generating electronic components **508A** and **508B** could be two different kind of electronic devices like CPUs and GPUs, or *vice versa,* with different thermal requirements. The rack-mounted assemblies **504** also include air-cooled heat-generating electronic components **528.**

As such, each of the rack-mounted processing assemblies **504** includes two pairs of hydraulic connections, one pair connected to a first liquid cooling loop **518A,** and the other pair connected to a second liquid cooling loop **518B.** Thus, the first liquid cooling loop **518A** comprises the first front-mounted heat exchanger **506A,** the first circulation conduit **520,** the forward path **520A,** the return path **520B,** the at least one first pump **512A,** and the at least one liquid cooling unit **510A** thermally-mounted onto the at least one high-temperature sensitive liquid-cooled heat-generating electronic components **508A.** Similarly, the second liquid cooling loop **518B** comprises the second rear-mounted heat exchanger **506B,** the second circulation conduit **522,** the forward path **522A,** the return path **522B,** the at least one second pump **512B,** and the at least one liquid cooling unit **510B** thermally-mounted onto the at least one high-temperature temperature liquid-cooled heat-generating electronic components **508B.** In some embodiments, some rack-mounted processing assemblies **504** may comprise only liquid-cooled heat-generating electronic components **508A** (resp. **508B)** without liquid-cooled heat-generating electronic components **508B** (resp. **508A).** Additionally, some rack-mounted processing assemblies **504** may incorporate a plurality of liquid cooling units **510A** (resp. **S10B)** and, in such cases, may also include integrated smaller cooling distribution units to fluidly-couple in parallel the corresponding liquid cooling units **510A** (resp. **S10B)** or with a combination of series and parallel arrangement.

Furthermore, in certain cases, a plate heat exchanger (PHEX) **530** may be implemented between the first and second liquid cooling loops **518A, 518B** for cooling improvement and/or safety concerns. All detailed implementations previously described for the autonomous server rack configuration **400** are applicable to the autonomous server rack configuration **500.**

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. An autonomous rack system (100), comprising:
a first rack structure (102) housing a first set of rack-mounted processing assemblies (104) containing liquid-cooled heat-generating electronic components (108) and air-cooled heat-generating electronic components (128), the first rack structure (102) having a front side and an opposing rear side;
a first air-to-liquid heat exchanger (106) mounted to the front side of the first rack structure (102) and configured to pull in cold ambient air towards the first set of rack-mounted processing assemblies (104);
a first liquid cooling loop (118), comprising:
a circulation conduit (120) conveying cooling liquid incorporating a forward path (120A) fluidly-coupled to an output of the first air-to-liquid heat exchanger (106) and a return path (120B) fluidly-coupled to an input of the first air-to-liquid heat exchanger (106);
at least one liquid cooling unit (110) thermally mounted onto the at least one liquid-cooled heat-generating electronic component (108) of the first set of processing assemblies (104) and fluidly-coupled to the circulation conduit to internally channel the cooling liquid therethrough; and
at least one first pump (112) to forcibly urge the flow of the cooling liquid through the forward path (120A), the liquid cooling unit (110), the return path (120B), and the first air-to-liquid heat exchanger (106);
wherein:
the cold ambient air pulled into the front side of the first rack structure (102) by the first air-to-liquid heat exchanger (106) is firstly warmed while cooling the first cooling liquid, flows across the first set of processing assemblies (104), such that the air secondly warmed by the air-cooled heat-generating electronic components (128) of the first set of processing assemblies (104) is expelled from the rear side of the first rack structure (102);
along the forward path (120A), the liquid cooling unit receives the cooling liquid from the output of the first air-to-liquid heat exchanger for internally channeling the cooling liquid therein; and
along the return path (120B), the liquid cooling unit returns the internally channeled liquid after being warmed by the liquid-cooled heat-generating electronic components of the first set of processing assemblies to the input of the first air-to-liquid heat exchanger.

2. The autonomous rack system of claim 1, wherein the at least one first pump (112) comprises two or more pumps arranged in series or parallel configurations.

3. The autonomous rack system of claim 1 or 2, wherein the firstly warmed air flowing across the first set of processing assemblies (104) comprises a temperature less than 37°C.

4. The autonomous rack system of anyone of claims 1 to 3, further comprising:
a second rack structure (202) juxtaposedly positioned at the rear of the first rack structure (102), the second rack structure (202) housing a second set of rack-mounted processing assemblies (204) containing air-cooled heat-generating electronic components (228), and liquid-cooled heat-generating electronic components (208) having operating thermal requirements that are more tolerant to higher temperature levels than the liquid-cooled heat-generating electronic components (108) of the first set of rack-mounted processing assemblies (104);
a second air-to-liquid heat exchanger (206) mounted to the rear side of the second rack structure (202) and configured to pull away warmed air from the second set of rack-mounted processing assemblies (204) and expel the hot air from the rear side of the second rack structure (202);
a second liquid cooling loop (218), comprising:
a circulation conduit (220) conveying cooling liquid incorporating a forward path (220A) fluidly-coupled to an output of the second air-to-liquid heat exchanger (206) and a return path (220B) fluidly-coupled to an input of the second air-to-liquid heat exchanger (206);
at least one liquid cooling unit (210) thermally mounted onto the at least one liquid-cooled heat-generating electronic component (208) of the second set of processing assemblies (204) and fluidly-coupled to the circulation conduit to internally channel the cooling liquid; and
at least one second pump (212) to forcibly urge the flow of the cooling liquid through the forward path (220A), the liquid cooling unit (210), the return path (220B), and the second air-to-liquid heat exchanger (206);
wherein:
the warm air expelled from the first set of processing assemblies (104) flows across the second set of rack-mounted processing assemblies (204), such that the air warmed-up by the air-cooled heat-generating components (228) of the second set of rack-mounted processing assemblies (204) is expelled from the rear side of the second rack structure (202) by the second air-to-liquid heat exchanger (206), where the expelled air gets warmer while cooling the second cooling liquid;
the second cooling liquid of the second liquid cooling loop (218) is warmer than the first cooling liquid of the first liquid cooling loop (118);
along the forward path (220A), the liquid cooling unit (210) receives the liquid from the output of the second air-to-liquid heat exchanger (206) for internally channeling the liquid therein; and
along the return path (220B), the liquid cooling unit (210) returns the internally channeled liquid after being warmed by the liquid-cooled heat-generating electronic components of the second set of processing assemblies (204) to the input of the second air-to-liquid heat exchanger (206).

5. The autonomous rack system of claim 4, wherein the first air-to-liquid heat exchanger (106) and/or the second air-to-liquid heat exchanger (206) comprise a finned heat exchanger (FHEX).

6. The autonomous rack system of claim 4 or 5, wherein the at least one second pump (212) comprises two or more pumps arranged in series or parallel configurations.

7. The autonomous rack system of anyone of claims 4 to 6, wherein the warm air expelled from the first set of processing assemblies (104) and directed to flow across the second set of rack-mounted processing assemblies (204) comprises a temperature less than 42°C.

8. The autonomous rack system of anyone of claims 4 to 7, further comprising at least one plate heat exchanger (PHEX) (230) installed between the first liquid cooling loop return path (120B) and the second liquid cooling loop return path (220B).

9. The autonomous rack system of anyone of claims 4 to 8, wherein:
the air and liquid temperatures are monitored;
the temperature of the heat-generating electronic components (108, 128, 208, 228) are monitored;
each of the first and second heat exchangers (106, 206) comprise fans, in which the rotation speed of the fans are controlled based on the monitored temperatures to provide the proper air flow throughout the first and second rack structures (102, 202);
the rotation speed of the at least one first and second pumps (112, 212) are controlled based on the monitored temperatures to deliver the right liquid flow rates for the first and second liquid cooling loops (118, 218);
the monitoring and the combined control of the rotation speeds of fans and pumps permit to reach adapted cooling fluid temperatures and optimize the cooling of the heat-generating electronic components (108, 128, 208, 228).

10. The autonomous rack system of anyone of claims 4 to 9, wherein the installation of multiple racks comprising the first and second rack structures (102, 202) include arranging the first and second rack structures (102, 202) within a datacenter to reduce the number of cold aisles and hot aisles and optimize footprint and server density.

11. An autonomous rack system (400), comprising:
a rack structure (402) housing a first set of rack-mounted processing assemblies (404A) containing liquid-cooled heat-generating electronic components (408A) and air-cooled heat-generating electronic components (428A) and a second set of rack-mounted processing assemblies (404B) containing air-cooled heat-generating electronic components (428B) and liquid-cooled heat-generating electronic components (408B) having operating thermal requirements that are more tolerant to higher temperature levels than the liquid-cooled heat-generating electronic components (408A) of the first set of rack-mounted processing assemblies (404A);
a first air-to-liquid heat exchanger (406A) mounted to a front side of the rack structure (402) and configured to pull in cold ambient air towards the first set of rack-mounted processing assemblies (404A);
a second air-to-liquid heat exchanger (406B) mounted to a rear side of the rack structure (402) and configured to pull away warmed air from the second set of rack-mounted processing assemblies (404B) and expel the hot air from the rear side of the rack structure (402);
a first liquid cooling loop (418A), comprising:
a first circulation conduit (420) conveying cooling liquid incorporating a forward path (420A) fluidly-coupled to an output of the first air-to-liquid heat exchanger (406A) and a return path (420B) fluidly-coupled to an input of the first air-to-liquid heat exchanger (406A);
at least one liquid cooling unit (410A) thermally mounted onto the at least one liquid-cooled heat-generating electronic component (408A) of the first set of processing assemblies (404A) and fluidly-coupled to the circulation conduit to internally channel the cooling liquid therethrough; and
at least one first pump (412A) to forcibly urge the flow of the cooling liquid through the forward path (420A), the liquid cooling unit (410A), the return path (420B), and the first air-to-liquid heat exchanger (406A);
a second liquid cooling loop (418B), comprising:
a second circulation conduit (422) conveying cooling liquid incorporating a forward path (422A) fluidly-coupled to an output of the second air-to-liquid heat exchanger (406B) and a return path (422B) fluidly-coupled to an input of the second air-to-liquid heat exchanger (406B);
at least one liquid cooling unit (410B) thermally mounted onto the at least one liquid-cooled heat-generating electronic component (408B) of the second set of processing assemblies (404B) and fluidly-coupled to the circulation conduit to internally channel the cooling liquid therethrough; and
at least one second pump (412B) to forcibly urge the flow of the cooling liquid through the forward path (422A), the liquid cooling unit (410B), the return path (422B), and the second air-to-liquid heat exchanger (406B);
wherein:
the cold ambient air pulled into the front side of the rack structure (402) by the first air-to-liquid heat exchanger (406A), is firstly warmed while cooling the first cooling liquid of the first liquid cooling loop (418A) and flows across the first and second sets of processing assemblies (404A, 404B), such that the air warmed by the air-cooled heat-generating electronic components (428A, 428B) of the first and second sets of processing assemblies (404A, 404B) is expelled from the rear side of the rack structure (402) by the second air-to-liquid heat exchanger (406B), where the expelled air gets warmer while cooling the second cooling liquid of the second liquid cooling loop (418B);
the second cooling liquid of the second liquid cooling loop (418B) is warmer than the first cooling liquid of the first liquid cooling loop (418A);
along the forward path (420A) of the first circulation conduit (420), the liquid cooling unit (410A) receives the cooling liquid from the output of the first air-to-liquid heat exchanger (406A) for internally channeling the cooling liquid therein and along the return path (420B), the liquid cooling unit (410A) returns the internally channeled liquid after being warmed by the liquid-cooled heat-generating electronic components of the first set of processing assemblies (404A) to the input of the first air-to-liquid heat exchanger (406A); and
along the forward path (422A) of the second circulation conduit (422), the liquid cooling unit (410B) receives the cooling liquid from the output of the second air-to-liquid heat exchanger (406B) for internally channeling the cooling liquid therein and along the return path (422B), the liquid cooling unit (410B) returns the internally channeled liquid after being warmed by the liquid-cooled heat-generating electronic components of the second set of processing assemblies (404B) to the input of the second air-to-liquid heat exchanger (406B).

12. The autonomous rack system of claim 11, wherein the at least one first pump (412A) and/or the at least one second pump (412B) comprise two or more pumps arranged in series or parallel configurations.

13. The autonomous rack system of claim 11 or 12, further comprising at least one plate heat exchanger (PHEX) (430) installed between the first liquid cooling loop return path (420B) and the second liquid cooling loop return path (422B).

14. The autonomous rack system of anyone of claims 11 to 13, wherein the warm air expelled from the first air-to-liquid heat exchanger (406A) directed to flow across the first and second set of rack-mounted processing assemblies (404A, 404B) comprises a temperature less than 37°C.

15. The autonomous rack system of anyone of claims 11 to 14, wherein the first air-to-liquid heat exchanger (406A) and/or the second air-to-liquid heat exchanger (406B) comprise a finned heat exchanger (FHEX).

16. A rack structure (502) housing a set of rack-mounted processing assemblies (504) that include air-cooled heat-generating electronic components (528), a first set of liquid-cooled heat-generating electronic components (508A), and a second set of liquid-cooled heat-generating electronic components (508B), in which the second set of liquid-cooled heat-generating electronic components (508B) manifest operating thermal requirements that are more tolerant to the higher temperature levels than the first set of liquid-cooled heat-generating electronic components (508A), the rack structure comprising:
a first air-to-liquid heat exchanger (506A) mounted to a front side of the rack structure (502) and configured to pull in cold ambient air towards the set of rack-mounted processing assemblies (504);
a second air-to-liquid heat exchanger (506B) mounted to a rear side of the rack structure (502) and configured to pull away warmed air from the set of rack-mounted processing assemblies (504) and expel the hot air from the rear side of the rack structure (502);
a first liquid cooling loop (518A), comprising:
a first circulation conduit (520) conveying cooling liquid incorporating a forward path (520A) fluidly-coupled to an output of the first air-to-liquid heat exchanger (506A) and a return path (520B) fluidly-coupled to an input of the first air-to-liquid heat exchanger (506A);
at least one liquid cooling unit (510A) thermally mounted onto the at least one first liquid-cooled heat-generating electronic component (508A) of the set of processing assemblies (504) and fluidly-coupled to the circulation conduit to internally channel the cooling liquid therethrough; and
at least one first pump (512A) to forcibly urge the flow of the cooling liquid through the forward path (520A), the liquid cooling unit (510A), the return path (520B), and the first air-to-liquid heat exchanger (506A);
a second liquid cooling loop (518B), comprising:
a second circulation conduit (522) conveying cooling liquid incorporating a forward path (522A) fluidly-coupled to an output of the second air-to-liquid heat exchanger (506B) and a return path (522B) fluidly-coupled to an input of the second air-to-liquid heat exchanger (506B);
at least one liquid cooling unit (510B) thermally mounted onto the at least one second liquid-cooled heat-generating electronic component (508B) of the set of processing assemblies (504) and fluidly-coupled to the circulation conduit to internally channel the cooling liquid therethrough; and
at least one second pump (512B) to forcibly urge the flow of the cooling liquid through the forward path (522A), the liquid cooling unit (510B), the return path (522B), and the second air-to-liquid heat exchanger (506B);
wherein:
the cold ambient air pulled into the front side of the rack structure (502) by the first air-to-liquid heat exchanger (506A), is firstly warmed while cooling the first cooling liquid of the first liquid cooling loop (518A) and flows across the set of processing assemblies (504), such that the air warmed by the air-cooled heat-generating electronic components (528) of the set of processing assemblies (504) is expelled from the rear side of the rack structure (502) by the second air-to-liquid heat exchanger (506B), where the expelled air gets warmer while cooling the second cooling liquid of the second liquid cooling loop (518B);
the second cooling liquid of the second liquid cooling loop (518B) is warmer than the first cooling liquid of the first liquid cooling loop (518A);
along the forward path (520A) of the first circulation conduit (520), the liquid cooling unit (510A) receives the cooling liquid from the output of the first air-to-liquid heat exchanger (506A) for internally channeling the cooling liquid therein and along the return path (520B), the liquid cooling unit (510A) returns the internally channeled liquid after being warmed by the first set of liquid-cooled heat-generating electronic components (508A) of the set of processing assemblies (504) to the input of the first air-to-liquid heat exchanger (506A); and
along the forward path (522A) of the second circulation conduit (522), the liquid cooling unit (510B) receives the cooling liquid from the output of the second air-to-liquid heat exchanger (506B) for internally channeling the cooling liquid therein and along the return path (522B), the liquid cooling unit (510B) returns the internally channeled liquid after being warmed by the second set of liquid-cooled heat-generating electronic components (508B) of the set of processing assemblies (504) to the input of the second air-to-liquid heat exchanger (506B).

## Amended claims

### Amended claims in accordance with Rule 137(2) EPC.

1. An autonomous rack system (100) having rack structures with self-contained liquid cooling loops for installation in various environments, comprising:
a first rack structure (102) housing a first set of rack-mounted processing assemblies (104) containing liquid-cooled heat-generating electronic components (108) and air-cooled heat-generating electronic components (128), the first rack structure (102) having a front side and an opposing rear side;
a first air-to-liquid heat exchanger (106) mounted to the front side of the first rack structure (102) and configured to pull in cold ambient air towards the first set of rack-mounted processing assemblies (104);
a first liquid cooling loop (118), comprising:
a circulation conduit (120) conveying cooling liquid incorporating a forward path (120A) fluidly-coupled to an output of the first air-to-liquid heat exchanger (106) and a return path (120B) fluidly-coupled to an input of the first air-to-liquid heat exchanger (106);
at least one liquid cooling unit (110) thermally mounted onto the at least one liquid-cooled heat-generating electronic component (108) of the first set of processing assemblies (104) and fluidly-coupled to the circulation conduit to internally channel the cooling liquid therethrough; and
at least one first pump (112) to forcibly urge the flow of the cooling liquid through the forward path (120A), the liquid cooling unit (110), the return path (120B), and the first air-to-liquid heat exchanger (106);
wherein:
the cold ambient air pulled into the front side of the first rack structure (102) by the first air-to-liquid heat exchanger (106) is firstly warmed while cooling the first cooling liquid, flows across the first set of processing assemblies (104), such that the air secondly warmed by the air-cooled heat-generating electronic components (128) of the first set of processing assemblies (104) is expelled from the rear side of the first rack structure (102);
along the forward path (120A), the liquid cooling unit receives the cooling liquid from the output of the first air-to-liquid heat exchanger for internally channeling the cooling liquid therein; and
along the return path (120B), the liquid cooling unit returns the internally channeled liquid after being warmed by the liquid-cooled heat-generating electronic components of the first set of processing assemblies to the input of the first air-to-liquid heat exchanger;
the autonomous rack system being **characterized in that** it further comprises:
a second rack structure (202) juxtaposedly positioned at the rear of the first rack structure (102), the second rack structure (202) housing a second set of rack-mounted processing assemblies (204) containing air-cooled heat-generating electronic components (228), and liquid-cooled heat-generating electronic components (208) having operating thermal requirements that are more tolerant to higher temperature levels than the liquid-cooled heat-generating electronic components (108) of the first set of rack-mounted processing assemblies (104);
a second air-to-liquid heat exchanger (206) mounted to the rear side of the second rack structure (202) and configured to pull away warmed air from the second set of rack-mounted processing assemblies (204) and expel the hot air from the rear side of the second rack structure (202);
a second liquid cooling loop (218), comprising:
a second circulation conduit (220) conveying cooling liquid incorporating a forward path (220A) fluidly-coupled to an output of the second air-to-liquid heat exchanger (206) and a return path (220B) fluidly-coupled to an input of the second air-to-liquid heat exchanger (206);
at least one liquid cooling unit (210) thermally mounted onto the at least one liquid-cooled heat-generating electronic component (208) of the second set of processing assemblies (204) and fluidly-coupled to the circulation conduit to internally channel the cooling liquid; and
at least one second pump (212) to forcibly urge the flow of the cooling liquid through the forward path w(220A), the liquid cooling unit (210), the return path (220B), and the second air-to-liquid heat exchanger (206);
wherein:
the warm air expelled from the first set of processing assemblies (104) flows across the second set of rack-mounted processing assemblies (204), such that the air warmed-up by the air-cooled heat-generating components (228) of the second set of rack-mounted processing assemblies (204) is expelled from the rear side of the second rack structure (202) by the second air-to-liquid heat exchanger (206), where the expelled air gets warmer while cooling the second cooling liquid;
the second cooling liquid of the second liquid cooling loop (218) is warmer than the first cooling liquid of the first liquid cooling loop (118);
along the forward path (220A), the liquid cooling unit (210) receives the liquid from the output of the second air-to-liquid heat exchanger (206) for internally channeling the liquid therein; and
along the return path (220B), the liquid cooling unit (210) returns the internally channeled liquid after being warmed by the liquid-cooled heat-generating electronic components of the second set of processing assemblies (204) to the input of the second air-to-liquid heat exchanger (206).

2. The autonomous rack system of claim 1, wherein the at least one first pump (112) comprises two or more pumps arranged in series or parallel configurations.

3. The autonomous rack system of claim 1 or 2, wherein the firstly warmed air flowing across the first set of processing assemblies (104) comprises a temperature less than 37°C.

4. The autonomous rack system of anyone of claims 1 to 3, wherein the first air-to-liquid heat exchanger (106) and/or the second air-to-liquid heat exchanger (206) comprise a finned heat exchanger (FHEX).

5. The autonomous rack system of anyone of claims 1 to 4, wherein the at least one second pump (212) comprises two or more pumps arranged in series or parallel configurations.

6. The autonomous rack system of anyone of claims 1 to 5, wherein the warm air expelled from the first set of processing assemblies (104) and directed to flow across the second set of rack-mounted processing assemblies (204) comprises a temperature less than 42°C.

7. The autonomous rack system of anyone of claims 1 to 6, further comprising at least one plate heat exchanger (PHEX) (230) installed between the first liquid cooling loop return path (120B) and the second liquid cooling loop return path (220B).

8. The autonomous rack system of anyone of claims 1 to 7, wherein:
the air and liquid temperatures are monitored;
the temperature of the heat-generating electronic components (108, 128, 208, 228) are monitored;
each of the first and second heat exchangers (106, 206) comprise fans, in which the rotation speed of the fans are controlled based on the monitored temperatures to provide the proper air flow throughout the first and second rack structures (102, 202);
the rotation speed of the at least one first and second pumps (112, 212) are controlled based on the monitored temperatures to deliver the right liquid flow rates for the first and second liquid cooling loops (118, 218); and
the monitoring and the combined control of the rotation speeds of fans and pumps permit to reach adapted cooling fluid temperatures and optimize the cooling of the heat-generating electronic components (108, 128, 208, 228).

9. The autonomous rack system of anyone of claims 1 to 8, wherein installation of multiple racks comprising the first and second rack structures (102, 202) include arranging the first and second rack structures (102, 202) within a datacenter to reduce the number of cold aisles and hot aisles and optimize footprint and server density.

10. A rack system (400) comprising:
a rack structure (402) housing a first set of rack-mounted processing assemblies (404A) containing liquid-cooled heat-generating electronic components (408A) and air-cooled heat-generating electronic components (428A) and a second set of rack-mounted processing assemblies (404B) containing air-cooled heat-generating electronic components (428B) and liquid-cooled heat-generating electronic components (408B) having operating thermal requirements that are more tolerant to higher temperature levels than the liquid-cooled heat-generating electronic components (408A) of the first set of rack-mounted processing assemblies (404A);
a first air-to-liquid heat exchanger (406A) mounted to a front side of the rack structure (402) and configured to pull in cold ambient air towards the first set of rack-mounted processing assemblies (404A);
a second air-to-liquid heat exchanger (406B) mounted to a rear side of the rack structure (402) and configured to pull away warmed air from the second set of rack-mounted processing assemblies (404B) and expel the hot air from the rear side of the rack structure (402);
a first liquid cooling loop (418A), comprising:
a first circulation conduit (420) conveying cooling liquid incorporating a forward path (420A) fluidly-coupled to an output of the first air-to-liquid heat exchanger (406A) and a return path (420B) fluidly-coupled to an input of the first air-to-liquid heat exchanger (406A);
at least one liquid cooling unit (410A) thermally mounted onto the at least one liquid-cooled heat-generating electronic component (408A) of the first set of processing assemblies (404A) and fluidly-coupled to the circulation conduit to internally channel the cooling liquid therethrough; and
at least one first pump (412A) to forcibly urge the flow of the cooling liquid through the forward path (420A), the liquid cooling unit (410A), the return path (420B), and the first air-to-liquid heat exchanger (406A);
a second liquid cooling loop (418B), comprising:
a second circulation conduit (422) conveying cooling liquid incorporating a forward path (422A) fluidly-coupled to an output of the second air-to-liquid heat exchanger (406B) and a return path (422B) fluidly-coupled to an input of the second air-to-liquid heat exchanger (406B);
at least one liquid cooling unit (410B) thermally mounted onto the at least one liquid-cooled heat-generating electronic component (408B) of the second set of processing assemblies (404B) and fluidly-coupled to the circulation conduit to internally channel the cooling liquid therethrough; and
at least one second pump (412B) to forcibly urge the flow of the cooling liquid through the forward path (422A), the liquid cooling unit (410B), the return path (422B), and the second air-to-liquid heat exchanger (406B);
wherein:
the cold ambient air pulled into the front side of the rack structure (402) by the first air-to-liquid heat exchanger (406A), is firstly warmed while cooling the first cooling liquid of the first liquid cooling loop (418A) and flows across the first and second sets of processing assemblies (404A, 404B), such that the air warmed by the air-cooled heat-generating electronic components (428A, 428B) of the first and second sets of processing assemblies (404A, 404B) is expelled from the rear side of the rack structure (402) by the second air-to-liquid heat exchanger (406B), where the expelled air gets warmer while cooling the second cooling liquid of the second liquid cooling loop (418B);
the second cooling liquid of the second liquid cooling loop (418B) is warmer than the first cooling liquid of the first liquid cooling loop (418A);
along the forward path (420A) of the first circulation conduit (420), the liquid cooling unit (410A) receives the cooling liquid from the output of the first air-to-liquid heat exchanger (406A) for internally channeling the cooling liquid therein and along the return path (420B), the liquid cooling unit (410A) returns the internally channeled liquid after being warmed by the liquid-cooled heat-generating electronic components of the first set of processing assemblies (404A) to the input of the first air-to-liquid heat exchanger (406A); and
along the forward path (422A) of the second circulation conduit (422), the liquid cooling unit (410B) receives the cooling liquid from the output of the second air-to-liquid heat exchanger (406B) for internally channeling the cooling liquid therein and along the return path (422B), the liquid cooling unit (410B) returns the internally channeled liquid after being warmed by the liquid-cooled heat-generating electronic components of the second set of processing assemblies (404B) to the input of the second air-to-liquid heat exchanger (406B).

11. The rack system of claim 10, wherein the at least one first pump (412A) and/or the at least one second pump (412B) comprise two or more pumps arranged in series or parallel configurations.

12. The rack system of claim 10 or 11, further comprising at least one plate heat exchanger (PHEX) (430) installed between the first liquid cooling loop return path (420B) and the second liquid cooling loop return path (422B).

13. The rack system of anyone of claims 10 to 12, wherein the warm air expelled from the first air-to-liquid heat exchanger (406A) directed to flow across the first and second set of rack-mounted processing assemblies (404A, 404B) comprises a temperature less than 37°C.

14. The rack system of anyone of claims 10 to 13, wherein the first air-to-liquid heat exchanger (406A) and/or the second air-to-liquid heat exchanger (406B) comprise a finned heat exchanger (FHEX).
